Europäisches Patentamt

European Patent Office

Office européen des brevets

(11) Numéro de publication : **0 314 560 B1**

(12) **FASCICULE DE BREVET EUROPEEN**

(45) Date de publication du fascicule du brevet :
**20.05.92 Bulletin 92/21**

(21) Numéro de dépôt : **88402678.2**

(22) Date de dépôt : **24.10.88**

(51) Int. Cl.⁵ : **H03K 4/08,** G01R 31/26

(54) **Générateur réglable de rampes successives de tensions, de pentes différentes.**

(30) Priorité : **26.10.87 FR 8714783**

(43) Date de publication de la demande :
**03.05.89 Bulletin 89/18**

(45) Mention de la délivrance du brevet :
**20.05.92 Bulletin 92/21**

(84) Etats contractants désignés :
**BE DE FR GB IT NL**

(56) Documents cités :
**EP-A- 0 113 975
FR-A- 2 489 963
US-A- 3 657 558
US-A- 3 676 697
US-A- 3 889 198
US-A- 4 176 398
Patent Abstracts of Japan, vol. 5, n 27 (E-46)
(699), 18th february 1981 & JP - A - 55 154 817
(Sonii TekutoronikusuK.K.) 02121980**

(73) Titulaire : **COMMISSARIAT A L'ENERGIE
ATOMIQUE Etablissement de Caractère
Scientifique Technique et Industriel
31/33, rue de la Fédération
F-75015 Paris (FR)**

(72) Inventeur : **Frances, Maurice
91, Avenue du Grésivaudan
F-38240 Meylan (FR)**
Inventeur : **Tabone, Claude
6, rue du Vercors
F-38600 Fontaine (FR)**
Inventeur : **Toffoli, Alain
Rue du 8 Mai - Le Gua
F-38450 Vif (FR)**

(74) Mandataire : **Mongrédien, André et al
c/o BREVATOME 25, rue de Ponthieu
F-75008 Paris (FR)**

## Description

La présente invention concerne un générateur réglable de rampes successives de tensions, de pentes différentes.

Cette invention s'applique à tout élément, composant ou circuit électrique ou électronique dont le fonctionnement ou le test nécessite l'alimentation électrique par une tension ayant la forme d'une rampe, c'est-à-dire une tension variant linéairement au cours du temps.

Notamment, pour le test d'un élément électrique ou électronique, il est souvent nécessaire d'appliquer à cet élément une tension variant linéairement au cours du temps, c'est-à-dire une tension en forme de rampe, de polarité positive ou négative ; la tension maximale et la pente de la rampe que l'on souhaite atteindre, doivent être contrôlées. Cette pente peut d'ailleurs présenter plusieurs valeurs au cours du temps, par exemple une première valeur pendant une première période, et une deuxième valeur pendant une seconde période. En effet, l'étude du comportement de l'élément ou composant peut ne présenter aucun intérêt pendant une première période courte au cours de laquelle la pente de la rampe est importante, tandis que ce comportement peut présenter un grand intérêt pendant une deuxième période au cours de laquelle la pente de la rampe est faible.

Le composant peut être par exemple un composant électronique de type MOS (Metal-Oxyde-Semiconducteur) pour lequel la tension de claquage de l'oxyde est un paramètre très important. Cette tension de claquage est obtenue en appliquant une tension en forme de rampe aux bornes de ce composant. Lorsque la tension de claquage est atteinte, l'oxyde cesse de se comporter en diélectrique et devient alors conducteur. La tension de claquage étant un paramètre intéressant, l'application à un composant d'une rampe de tensions unique peut rendre la durée du test assez longue ; cette durée pourrait être réduite de façon importante en appliquant au composant une première rampe de tensions de pente importante au cours d'une faible période, et une deuxième rampe de tensions de plus faible pente au cours d'une période plus importante, jusqu'à l'obtention de la tension de claquage.

On constate qu'il est donc nécessaire de disposer d'un générateur réglable de rampe de tensions, de préférence programmable, qui permet de régler facilement la pente de la rampe, par exemple pour obtenir une première pente au cours d'une première période, et une deuxième pente au cours d'une deuxième période, cette pente représentant en fait la vitesse de variation de la tension au cours de chaque période. Il peut également être utile que la tension soit de polarité positive ou négative par rapport à une tension ou masse de référence. Enfin, on doit pouvoir contrôler l'instant où l'on souhaite voir cesser l'application de la rampe de tensions au composant testé, par exemple lorsque la tension de claquage est atteinte, lors du test d'un composant de type MOS.

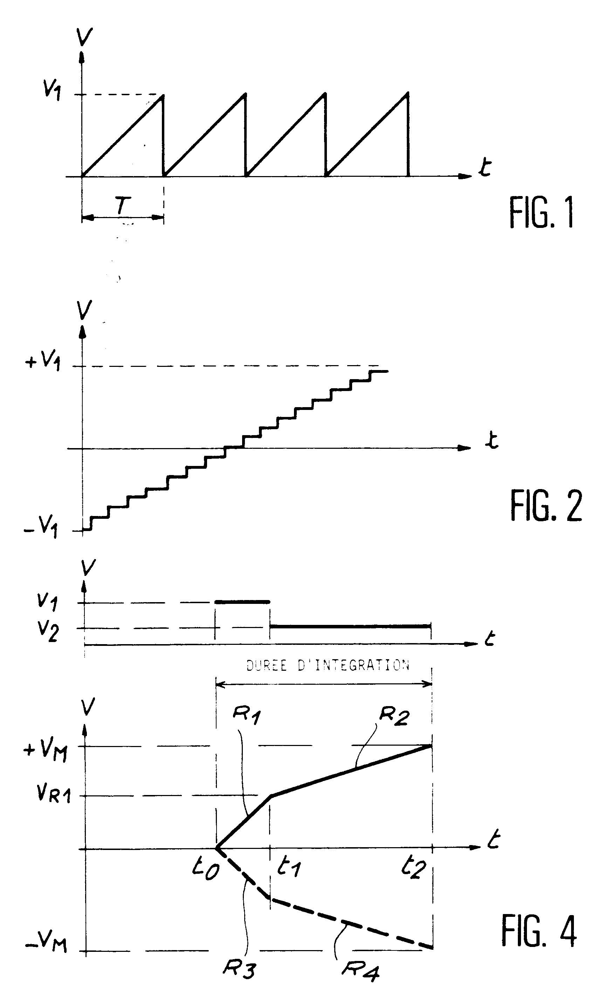

Il existe des générateurs de signaux triangulaires ou en dents de scie, de type programmable qui fournissent des signaux tels que représentés sur le chronogramme de la figure 1 qui représente la tension V fournie par le générateur, au cours du temps t. Dans ce type de générateur, la fréquence 1/T ainsi que la tension crête V1 sont réglables ou programmables, mais les performances sont très limitées : La tension V1 ne dépasse pas 40 volts et n'est pas bipolaire. La fréquence 1/T n'est pas l'expression directe de la pente en volts par seconde, de chaque rampe de chaque dent de scie. Les rampes sont répétées en permanence, alors que pour chaque test il ne faut absolument pas appliquer au composant une succession de rampes identiques. Enfin, il est impossible d'interrompre une rampe à un instant quelconque, par exemple lors du claquage d'un composant MOS.

Il existe aussi un autre générateur, de type programmable, utilisant un calculateur qui permet d'obtenir une rampe de tension V de pente et de durée t réglables et qui peut être bipolaire, telle que représentée sur le chronogramme de la figure 2. Ce type de générateur est toutefois performant (la tension ne peut varier mque de -V1=-4 volts à +V1=+4 volts), et la rampe fournie présente une forme en escalier. Ce générateur comprend un calculateur relié à une mémoire dans laquelle on enregistre sous forme binaire les points d'une droite correspondant la rampe que l'on souhaite obtenir.

Les valeurs binaires sont lues dès que l'on souhaite obtenir la rampe correspondante, et elles sont converties en tension par un convertisseur numérique-analogique. Le générateur fournit la rampe correspondante de tension. Cette rampe présente une forme en escalier qui est génante pour effectuer un test correct.

Ce type de générateur, outre le fait qu'il est peu performant et que la rampe à une forme en escalier, a pour inconvénient de nécessiter un délai important pour obtenir une nouvelle rampe, puisqu'il faut calculer tous les points de cette nouvelle rampe.

Un autre générateur qui fournit des rampes de tension séparées par des paliers intermédiaires et décrit dans le document US-A-4 176 398.

Un autre générateur qui fournit une rampe de tension de durée règlable est aussi décrit dans le document FR-A-2 489 963. Ce générateur, utilisé dans des essais de diélectriques, ne peut fournir des rampes successives dont on peut programmer à la fois pour chaque rampe la pente, la durée et l'arrêt. Le générateur décrit dans ce document permet seulement d'appliquer à un diélectrique une impulsion d'amplitude prédéterminée.

L'invention a pour but de remédier à ces inconvénients grâce à un générateur réglable de rampe de tensions, qui permet de régler ou de programmer très facilement la valeur de la pente de la rampe (ou vitesse de variation de la tension), la durée de la rampe et l'arrêt de celle-ci. Ce générateur permet aussi de fournir des rampes de tensions successives, de durées et de pentes différentes, de type bipolaire, dont la valeur de tension peut être importante (+180 volts). Enfin, chaque rampe obtenue présente une forme linéaire très rigoureuse et l'obtention d'une rampe de pente et de durée prédéterminées est très rapide.

L'invention a pour objet un générateur réglable de rampes successives de tensions de pentes différentes, comportant un générateur de tensions échelons de valeurs prédéterminées réglables, fournissant un signal de tensions échelon sur une sortie, un intégrateur ayant une entrée reliée à la sortie du générateur de tensions échelon et des moyens de commande, reliés à une entrée de l'intégrateur pour commander l'arrêt de l'intégration des tensions échelon lorsque la tension des rampes successives atteint une amplitude finale de valeur prédéterminée, les rampes successives étant fournies par une sortie de l'intégrateur, caractérisé en ce qu'il comporte un premier amplificateur relié à la sortie de l'intégrateur pour fournir sur une sortie lesdites rampes successives de tensions, amplifiées et de polarité positive par rapport à une tension de référence, un deuxième amplificateur relié à la sortie de l'intégrateur pour fournir sur une sortie lesdites rampes successives de tensions, amplifiées et de polarité négative par rapport à la tension de référence, et des moyens de sélection d'amplificateur, reliés à la sortie de l'intégrateur, pour sélectionner l'amplification des rampes de tensions par l'un ou l'autre des amplificateurs.

Selon une autre caractéristique, le générateur comporte en outre un processeur relié à une mémoire dans laquelle sont enregistrées des informations correspondant aux valeurs prédéterminées des échelons de tension, de chaque amplitude finale des rampes successives de tensions, et à la sélection de l'un des deux amplificateurs, ce processeur étant relié respectivement par des sorties de commande à une entrée de réglage de tensions du générateur de tensions échelon, à une entrée de commande des moyens de commande pour obtenir l'amplitude finale des rampes successives de tensions, et à une entrée de commande des moyens de sélection pour commander la sélection de l'un ou l'autre des amplificateurs.

Selon une autre caractéristique, le générateur comporte en outre des moyens de mesure de courant et/ou de tension appliqués à un élément à tester, cet élément étant relié aux sorties des premier et deuxième amplificateurs et à une tension de référence, une sortie de chacun des moyens de mesure étant reliée à une entrée du processeur pour que celui-ci commande l'arrêt de l'intégration lorsque la tension et/ou le courant appliqués à l'élément à tester atteignent des seuils de courant et/ou de tension.

Les caractéristiques et avantages de l'invention ressortiront mieux de la description qui va suivre donnée en référence aux figures annexées dans lesquelles :
– la figure 1 a déjà été décrite et représente un chronogramme de signaux de tension fournis par un générateur connu dans l'état de la technique,
– la figure 2 a déjà été décrite et représente un chronogramme de signaux de tension fournis par un autre générateur connu dans l'état de la technique,
– la figure 3 représente schématiquement un générateur de rampe de tensions, conforme à l'invention,
– la figure 4 est un chronogramme représentant un signal de rampe de tensions, fourni par le générateur de l'invention.

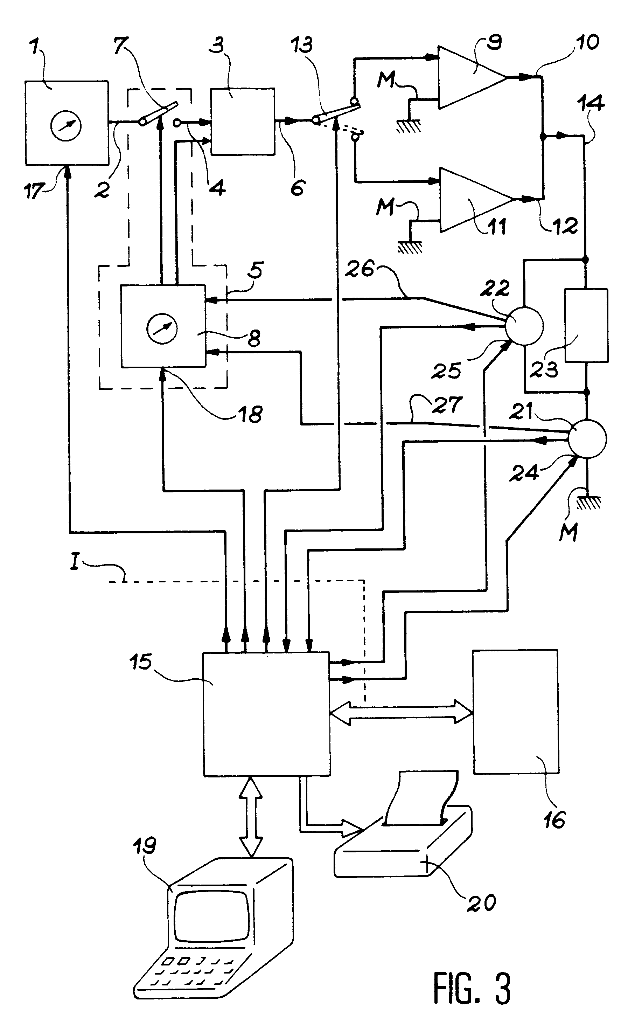

La figure 3 représente schématiquement un générateur de rampe de tensions, conforme à l'invention.

Ce générateur de rampes de tensions comporte un générateur 1 de tensions échelon, cette tension échelon présentant une amplitude de valeur prédéterminée réglable. Le signal de tensions échelon est fourni sur une sortie 2 du générateur 1. Il est appliqué à un intégrateur 3 ayant une entrée 4 reliée à la sortie 2 du générateur de tensions échelon 1. Le générateur de tensions échelon peut d'ailleurs fournir des signaux successifs de tensions échelon, présentant des amplitudes différentes.

Des moyens de commande 5 sont reliés à l'entrée 4 de l'intégrateur pour régler la durée d'intégration du signal ou des signaux de tensions échelon du générateur 1. La ou les rampes de tensions sont fournies sur une sortie 6 de l'intégrateur 3.

Les moyens 5 de commande de durée d'intégration comprennent par exemple un interrupteur de type électronique 7, dont la durée de fermeture et l'ouverture sont commandées par exemple par des moyens monostables 8 à durée de conduction réglable. Le réglage de la durée de conduction peut être effectué, soit manuellement, soit de préférence, comme on le verra plus loin en détail, à l'aide d'un processeur. La rampe ou les rampes de tensions qui sont fournies sur la sortie 6 de l'intégrateur 3 présentent une ou des pentes qui dépendent respectivement, comme on le verra plus loin en détail, de l'amplitude ou des amplitudes des tensions échelon fournie à l'intégrateur 3 par le générateur 1, et de la durée d'application de cette ou de ces tensions échelon appliquées à l'entrée 4 de l'intégrateur 3. Toutefois, que ce soit manuellement, ou à l'aide du processeur et pour faciliter l'utilisation du générateur, c'est l'amplitude de la tension finale des rampes successives de tensions qui est réglée de façon prédéterminée. En effet, à une amplitude de tension finale prédéterminée des rampes, correspond une durée totale d'intégration des tensions échelon successives fournies par le générateur.

Le générateur de l'invention comprend aussi un premier amplificateur 9, de type opérationnel par exemple, relié à la sortie 6 de l'intégrateur, pour fournir sur une sortie 10, la ou les rampes de tensions amplifiée et de polarité positive par rapport à une tension ou masse de référence M. Dans ce montage, c'est l'entrée positive de l'amplificateur opérationnel 9 qui est reliée à la sortie de l'intégrateur, tandis que l'entrée négative de cet amplificateur est reliée à la masse de référence M.

Le générateur comporte aussi un deuxième amplificateur 11, de type opérationnel par exemple, relié à la sortie 6 de l'intégrateur 3, pour fournir sur une sortie 12 la ou les rampes de tensions amplifiée et de polarité négative par rapport à la masse de référence M. Dans ce montage, c'est l'entrée négative de l'amplificateur opérationnel qui est reliée à la sortie de l'intégrateur 3, tandis que l'entrée positive de cet amplificateur est reliée à la masse de référence.

Le générateur de l'invention comprend aussi des moyens 13 de sélection de l'un ou de l'autre des amplificateurs ; ces moyens de sélection sont reliés à la sortie 6 de l'intégrateur 3. Ils peuvent être constitués par exemple par un commutateur qui permet d'obtenir, à la sortie des amplificateurs, dans la ligne 14, soit une ou des rampes de tensions positive, soit une ou des rampes de tensions négative par rapport à la masse de référence.

Le commutateur 13 est de préférence un commutateur de type électronique commandé, comme on le verra plus loin en détail, par un processeur.

Les valeurs des tensions échelon, qui peuvent être réglées manuellement, peuvent aussi être réglées par des signaux de commande fournis par ce processeur.

Une mémoire 16 est reliée au processeur 15. Cette mémoire permet d'enregistrer des informations qui correspondent à la valeur prédéterminée des amplitudes des échelons de tensions que l'on souhaite choisir, lorsque l'on souhaite obtenir plusieurs rampes successives, de pentes différentes. Ces informations permettent au processeur de commander le générateur d'échelon de tensions 1 par un signal appliqué, sur une entrée de commande 17 de ce générateur. On ne décrira pas ici en détail le réglage de ce générateur puisque ce type de réglage est connu dans l'état de la technique.

Des informations correspondant à l'amplitude finale des rampes successives que l'on souhaite obtenir, sont également enregistrées dans la mémoire 16. Ces informations permettent de commander, par un signal de sortie du processeur, une entrée de commande 18 des moyens monostables 8. En effet, le processeur 15, qui possède une horloge interne, est capable de convertir cette amplitude finale en durée totale d'intégration. Le signal du sortie de monostable 8 est appliqué à une entrée de l'intégrateur 3 pour fixer la durée totale d'intégration des tensions échelon successives.

Enfin, la mémoire 16 permet également d'enregistrer des informations correspondant à la sélection de l'un ou l'autre des amplificateurs 9, 11. Ces informations permettent de commander, grâce à un signal de commande fourni par une sortie du processeur 15, le commutateur 13 qui peut être de type électronique.

On a également représenté sur cette figure, un terminal 19 à écran de visualisation par exemple qui permet un dialogue avec le processeur 15 ; ce terminal peut aussi permettre l'enregistrement dans la mémoire 16, des informations essentielles au réglage et à la commande des différents moyens du générateur de l'invention.

Une imprimante 20 peut être également reliée au processeur 15 pour fournir des résultats de mesure, comme on le verra plus loin en détail.

Le générateur comporte aussi des moyens de mesure de courant 21, et/ou de tension 22, appliqués à un élément testé 23. Cet élément est relié aux sorties 10, 12 des premier et deuxième amplificateurs 9, 11, par la ligne 14. Il est aussi relié à la masse de référence M. Les valeurs de tension et/ou de courant, fournies par les moyens de mesure 21, 22 sont appliquées au processeur 15. Ces moyens peuvent présenter différentes échelles de mesure et leur réglage peut être effectué grâce à des signaux de commande appliqués sur leurs entrées 24, 25, par des sorties correspondantes du processeur 15. Ces signaux de commande d'échelle de mesure sont bien entendu obtenus à partir d'informations correspondantes enregistrées dans la mémoire 16. Une conversion analogique-numérique des valeurs de tension et/ou de courant peut être effectuée par un convertisseur interne au processeur par exemple, non représenté sur la figure.

Le processeur 15 qui reçoit les valeurs numériques de tension et/ou de courant, peut commander l'arrêt de l'intégration, grâce à un signal de commande appliqué aux moyens monostables 8, par exemple lorsque les valeurs de la tension et/ou du courant appliquées à l'élément 23 atteignent des seuils. Ces seuils correspondent par exemple à des valeurs caractéristiques recherchées de tensions, telles que la tension de claquage de l'élément testé, et/ou à des seuils prédéterminés de sécurité préalablement enregistrés dans la mémoire 16. L'arrêt total de l'intégration est alors provoqué par ouverture de l'interrupteur 7.

Dans le cas où on recherche une tension de claquage d'un élément, l'instruction d'arrêt de l'intégration est fournie par le processeur 15, dès que la tension appliquée à l'élément à tester est proche de la tension de claquage. La valeur du courant fourni par les moyens de mesure 21 permet au calculateur de déterminer l'instant auquel l'intégration doit être arrêtée pour éviter le claquage de l'élément testé ; cet instant correspond à l'ouverture de l'interrupteur 7. Ces valeurs correspondent respectivement à des informations de seuils préalablement enregistrées dans la mémoire 16 du processeur 15. Il est évident que le processeur 15 est relié aux autres moyens du générateur, par une interface I, représentée de manière très schématique sur la figure. Cette interface, de type universel, obéit à la norme IEEE 488.

La figure 4 est un chronogramme des rampes de tensions appliquées à l'élément 23 à tester, par exemple par la sortie 10 de polarité positive, de l'amplificateur 9. Ces rampes de tensions sont représentées en R1 et R2 sur la figure.

La rampe de tensions R1 d'amplitude finale VR1 est obtenue par intégration de l'échelon de tension d'amplitude V1, pendant la durée t1-t0. La rampe de tensions R2 d'amplitude finale VM, est obtenue par intégration de l'échelon de tension d'amplitude V2, pendant la durée t2-t1. La durée totale d'intégration t2-t0 est la somme des durées d'intégration des tensions échelon V1 et V2. C'est le calculateur qui calcule, grâce à son horloge interne, la durée totale d'intégration nécessaire à l'obtention de l'amplitude finale des rampes de tensions successives. La fin de l'intégration peut aussi être déterminée par les valeurs de seuils, déterminées par les moyens de mesure 21 ou 22, lorsque l'une et/ou l'autre des valeurs mesurées ont dépassé des seuils prédéterminés de sécurité par exemple. Dans ce cas, ces moyens de mesure comportent des détecteurs de seuils incorporés pour fournir sur des sorties 26, 27, des signaux de commande appliqués aux moyens monostables 8, pour arrêter l'intégration, grâce à l'ouverture de l'interrupteur 7.

On voit sur cette figure que l'amplitude finale $V_M$ maximum de la rampe de tensions R2 est obtenue au cours d'un intervalle de temps t2-t0 qui est bien inférieur à la durée qui aurait été nécessaire pour obtenir cette amplitude par intégration d'une seule tension échelon.

Un signal symétrique en forme de deux rampes successives R3, R4 serait obtenu de la même façon sur la sortie 12 de l'amplificateur 11, par basculement du commutateur 13.

Le générateur de l'invention permet de programmer ou de régler des rampes successives de tensions ayant une forme quelconque, et d'interrompre ces rampes à n'importe quel instant.

Les pentes des rampes de tensions fournies par l'intégrateur étant exprimées en volts/seconde, la mesure numérique de tension n'est pas nécessaire puisqu'il suffit, pour déterminer la tension (par exemple de claquage), de connaître, à partir d'une horloge interne au processeur, la durée totale d'intégration des différentes tensions échelon.

## Revendications

1. Générateur réglable de rampes de tensions successives de pentes différentes, comportant un générateur (1) de tensions échelon successives à valeurs d'amplitudes prédéterminées règlables pour chaque rampe, fournissant un signal de tensions échelon sur une sortie (2), un intégrateur (3) ayant une entrée (4) reliée à la sortie (2) du générateur de tensions échelon (1) et des moyens de commande (5), reliés à une entrée (4) de l'intégrateur (3) pour commander l'arrêt de l'intégration des tensions échelon successives lorsque la tension des rampes successives atteint une amplitude finale de valeur prédéterminée, les rampes de tensions étant fournies sur une sortie (6) de l'intégrateur, caractérisé en ce qu'il comporte un premier amplificateur (9) relié à la sortie (6) de l'intégrateur (3) pour fournir sur une sortie (10) lesdites rampes de tensions successives, amplifiées et de polarité positive par rapport à une tension de référence (M), un deuxième amplificateur (11) relié à la sortie (6) de l'intégrateur (3) pour fournir sur une sortie (12) lesdites rampes de tensions, amplifiées et de polarité négative par rapport à la tension de référence (M), et des moyens (13) de sélection d'amplificateur, reliés à la sortie (6) de l'intégrateur, pour sélectionner l'amplification des rampes de tensions par l'un ou l'autre des amplificateurs (9 ou 11).

2. Générateur selon la revendication 1, caractérisé en ce qu'il comprend en outre un processeur (15) relié à une mémoire (16) dans laquelle sont enregistrées des informations correspondant à la valeur prédéterminée de chaque amplitude d'échelon de tension, de l'amplitude finale des rampes de tensions successives et à la sélection de l'un des deux amplificateurs (9 ou 11), ce processeur étant relié respectivement par des sorties de commande à une entrée (17) de réglage de tensions du générateur de tensions échelon (1), à une entrée (18) de commande des moyens (5) de commande de l'intégrateur pour obtenir l'amplitude finale des rampes de tensions, et à une entrée de commande des moyens de sélection (13) pour commander la sélection de l'un ou l'autre des amplificateurs.

3. Générateur selon la revendication 2, caractérisé en ce qu'il comporte en outre des moyens (21, 22) de mesure de courant et/ou de tension appliqués à un élément (23) à tester, cet élément (23) étant relié aux sorties (10, 12) des premier et deuxième amplificateurs (9, 11) et à une tension de référence (M), une sortie de chacun des moyens de mesure étant reliée à une entrée du processeur (15) pour que celui-ci commande l'enregistrement dans la mémoire, des valeurs mesurées de courant et/ou de tension.

4. Générateur, selon la revendication 3, caractérisé en ce que les moyens de mesure sont reliés au processeur pour que celui-ci commande l'arrêt total de l'intégration lorsque la tension et/ou le courant appliqué à l'élément (23) à tester atteignent une valeur de seuil de courant et/ou de tension à ne pas dépasser.

5. Générateur selon la revendication 3, caractérisé en ce que les moyens de mesure de courant et/ou de tension comportent des détecteurs de seuils incorporés, ces moyens de mesure étant reliés aux moyens de commande d'intégration, pour commander l'arrêt total de l'intégration dès qu'un seuil est atteint.

**Patentansprüche**

1. Einstellbarer Generator für aufeinanderfolgende Spannungsrampen mit verschiedenem Anstieg mit einem Generator (1) für aufeinanderfolgende Spannungsstufen mit vorgegebenen Amplitudenwerten, die für jede Rampe einstellbar sind, der ein Spannungsstufensignal an einem Ausgang (2) erzeugt, mit einem Integrator (3) mit einem mit dem Ausgang (2) des Spannungsstufengenerators (1) verbundenen Eingang (4) und mit Steuerungsvorrichtungen (5), die mit einem Eingang (4) des Integrators (3) verbunden sind, um das behalten der Integration der aufeinanderfolgenden Spannungsstufen zu steuern, sobald die Spannung der aufeinanderfolgenden Rampen eine endgültige Amplitude mit einem vorgegebenen Wert erreicht, wobei die Spannungsrampen an einem Ausgang (6) des Integrators erzeugt werden, dadurch gekennzeichnet, daß er umfaßt: einen ersten Verstärker (9), der mit dem Ausgang (6) des Integrators (3) verbunden ist, um auf einem Ausgang (10) die aufeinanderfolgenden Spannungsrampen verstärkt und mit einer positiven Polarität bezüglich einer Bezugsspannung (M) zu erzeugen, einen zweiten Verstärker (11), der mit dem Ausgang (6) des Integrators (3) verbunden ist, um auf einem Ausgang (12) die aufeinanderfolgenden Spannungsrampen verstärkt und mit einer negativen Polarität bezüglich der Bezugsspannung (M) zu erzeugen, und Vorrichtungen (13) zur Verstärkerauswahl, die mit dem Ausgang (6) des Integrators verbunden sind, um die Verstärkung der Spannungsrampen durch den einen oder den anderen der Verstärker (9 oder 11) auszuwählen.

2. Verstärker nach Anspruch 1, dadurch gekennzeichnet, daß er außerdem einen Prozessor (15) umfaßt, der mit einem Speicher (16) verbunden ist, in dem Information hinsichtlich des vorgegebenen Wertes jeder Spannungstufenamplitude, der endgültigen Amplitude der aufeinanderfolgenden Spannungsrampen und der Auswahl des einen der beiden Verstärker (9 oder 11) gespeichert sind, wobei dieser Prozessor jeweils durch Steuerungsausgänge mit einem Eingang (17) zur Spannungsregelung des Spannungsstufengenerators (1), mit einem Steuerungseingang der Vorrichtungen (5) zum Steuern des Integrators zum Erhalten der endgültigen Amplitude der Spannungsrampen und mit einem Steuerungseingang der Auswahlvorrichtungen (13) zum Steuern der Auswahl des einen oder des anderen der Verstärker verbunden ist.

3. Generator nach Anspruch 2, dadurch gekennzeichnet, daß er außerdem Vorrichtungen (21, 22) zum Messen des an ein zu testendes Element (23) angelegten Stroms und/oder der Spannung umfaßt, wobei dieses Element (23) mit den Ausgängen (10, 12) der ersten und zweiten Verstärker (9, 11) und mit einer Bezugsspannung (M) verbunden ist, wobei ein Ausgang jeder Meßvorrichtung mit einem Eingang des Prozessors (15) verbunden ist, damit dieser das Speichern der gemessenen Strom- und/oder Spannungswerte in dem Speicher steuert.

4. Generator nach Anspruch 3, dadurch gekennzeichnet, daß die Meßvorrichtungen mit dem Prozessor verbunden sind, damit dieser das gesamte Anhalten der Integration steuert, sobald die an das zu testende Element (23) angelegte Spannung und/oder der Strom einen nicht zu übersteigenden Strom- und/oder Spannungsschwellwert erreicht.

5. Generator nach Anspruch 3, dadurch gekennzeichnet, daß die Strom- und/oder Spannungsmeßvorrichtungen eingebaute Schwelldetektoren umfassen, wobei diese Meßvorrichtungen mit den Integrationssteuerungsvorrichtungen verbunden sind, um das gesamte Anhalten der Integration zu steuern, sobald ein Schwellwert erreicht ist.

**Claims**

1. Adjustable generator of successive voltage ramps of different slopes, comprising a generator (1) of successive step voltages at pre-determined values of amplitude adjustable for each ramp, delivering a step voltages signal on one output (2), an integrator (3) having one input (4) connected to the output (2) of the step voltages generator (1) and means of control (5), connected to one input (4) of the integrator (3) to control the stopping of the integration of the successive step voltages when the voltage of the successive ramps reaches a final amplitude of pre-determined value, the voltage ramps being delivere 1 on one output (6) of the integrator, characterised in that it comprises a first amplifier (9) connected to the output (6) of the integrator (3) to deliver, on one output (10), the said successive voltage ramps, amplified and of positive polarity with respect to a reference voltage (M), a second amplifier (11) connected to the output (6) of the integrator (3) to deliver, on one output (12), the said voltage ramps, amplified and of negative polarity with reapect to the reference voltage (M), and means (13) of selection of an amplifier, connected to the output (6) of the integrator, to select the amplification of the voltage ramps by one or the other of the amplifiers (9 or 11).

2. Generator according to Claim 1, characterised in that it comprises, moreover, a processor (15) connected to a memory (16) in which are recorded data corresponding to the pre-determined value of each voltage step amplitude, and of the final amplitude of the successive voltage ramps and to the selection of one of the two amplifiers (9 or 11), this processor being connected respectively by control outputs to one input (17) for adjusting the voltages of the step voltages generator (1), to a control input (18) of the means of control (5) of the integrator to obtain the final amplitude of the voltage ramps, and to one control input of the means of selection (13) to control the selection of one or the other of the amplifiers.

3. Generator according to Claim 2, characterised in that it comprises, moreover, means (21, 22) of measurement of current and/or of voltage applied to an element (23) to be tested, this element (23) being connected to the outputs (10, 12) of the first and second amplifiers (9, 11) and to a reference voltage (M), one output of each of the means of measurement being connected to one input of the processor (15) so that the latter controls the recording in the memory of the measured values of current and/or of voltage.

4. Generator, according to Claim 3, characterised in that the means of measurement are connected to the processor so that the latter controls the complete stopping of the integration when the voltage and/or the current applied to the element (23) to be tested reach a threshold value of current and/or of voltage which is not to be exceeded.

5. Generator according to Claim 3, characterised in that the means of measurement of current and/or of voltage comprise incorporated threshold detectors, these means of measurement being connected to the means of control of integration, to control the complete stopping of the integration as soon as a threshold is reached.

FIG. 1

FIG. 2

DUREE D'INTEGRATION

FIG. 4

FIG. 3